# EUROPEAN PATENT APPLICATION

(11) **EP 4 287 248 A1**
(43) Date of publication of application: **06.12.2023**
(21) Application number: 23161217.7
(22) Date of filing: 10.03.2023
(51) Int. Cl.: H01L 23/00, H01L 25/00, H01L 25/18

(54) **SEMICONDUCTOR DEVICE AND METHOD OF MANUFACTURING THE SAME**

(30) Priority: 01.06.2022 JP 2022089923; 14.02.2023 DE 102023103559
(71) Applicant: Kioxia Corporation, Tokyo 105-0023 (JP)
(72) Inventor: Ashidate, Hiroaki, Tokyo, 105-0023 (JP); Kato, Hisashi, Tokyo, 105-0023 (JP); Takeishi, Tomoyuki, Tokyo, 105-0023 (JP)
(74) Representative: Marks & Clerk LLP

(57) **Abstract**

In one embodiment, a semiconductor device includes a first substrate (11), a first insulator (13) provided on the first substrate, a first pad (17) provided in the first insulator, a second insulator (21) provided on the first insulator, and a second pad (22) provided in the second insulator, disposed on the first pad, and being in contact with the first pad. The device further includes a third pad (29) provided in the second insulator, and disposed above the second pad, a third insulator (31) provided on the second insulator, and a fourth pad (32) provided in the third insulator, disposed on the third pad, and being in contact with the third pad. Furthermore, a shape of the third (29) or fourth pad (32) is different from a shape of the first (17) or second pad (22). Also disclosed is a method of manufacturing said semiconductor device.

## Description

### FIELD

Embodiments described herein relate to a semiconductor device and a method of manufacturing the same.

### BACKGROUND

In a case where a semiconductor device is manufactured by bonding three or more substrates via inter layer dielectrics, there is a problem of how to form bonding pads in the inter layer dielectrics.

### BRIEF DESCRIPTION OF THE DRAWINGS

FIG. 1 is a cross-sectional view showing a structure of a semiconductor device of a first embodiment;
FIGS. 2A and 2B are cross-sectional views showing structures of memory cell arrays 26 and 36 of the first embodiment;
FIGS. 3 to 7 are cross-sectional views showing a method of manufacturing the semiconductor device of the first embodiment;
FIG. 8 is a cross-sectional view showing a structure of a semiconductor device of a comparative example of the first embodiment;
FIG. 9 is a cross-sectional view showing the structure of the semiconductor device of the first embodiment;
FIGS. 10A to 10D are plan views showing a first example of metal pads 17, 22, 29 and 32 of the first embodiment;
FIGS. 11A to 11D are plan views showing a second example of the metal pads 17, 22, 29 and 32 of the first embodiment;
FIGS. 12A to 12D is plan views showing a third example of the metal pads 17, 22, 29 and 32 of the first embodiment;
FIGS. 13A and 13B are cross-sectional views showing a fourth example of the metal pads 17, 22, 29 and 32 of the first embodiment;
FIGS. 14A to 15B are cross-sectional views for explaining advantages of the semiconductor device of the first embodiment;
FIG. 16 is a cross-sectional view showing a structure of a semiconductor device of a second embodiment;
FIGS. 17A and 17B are cross-sectional views for comparing the semiconductor device of the second embodiment and a semiconductor device of a comparative example thereof;
FIG. 18 is a cross-sectional view showing a structure of a semiconductor device of a first modification of the second embodiment;
FIGS. 19A to 19C are cross-sectional views showing structures of semiconductor devices of second to fourth modifications of the second embodiment;
FIGS. 20A to 20D are cross-sectional views showing a method of manufacturing a semiconductor device of a third embodiment; and
FIGS. 21A to 21D are cross-sectional views showing a method of manufacturing a semiconductor device of a modification of the third embodiment.

### DETAILED DESCRIPTION

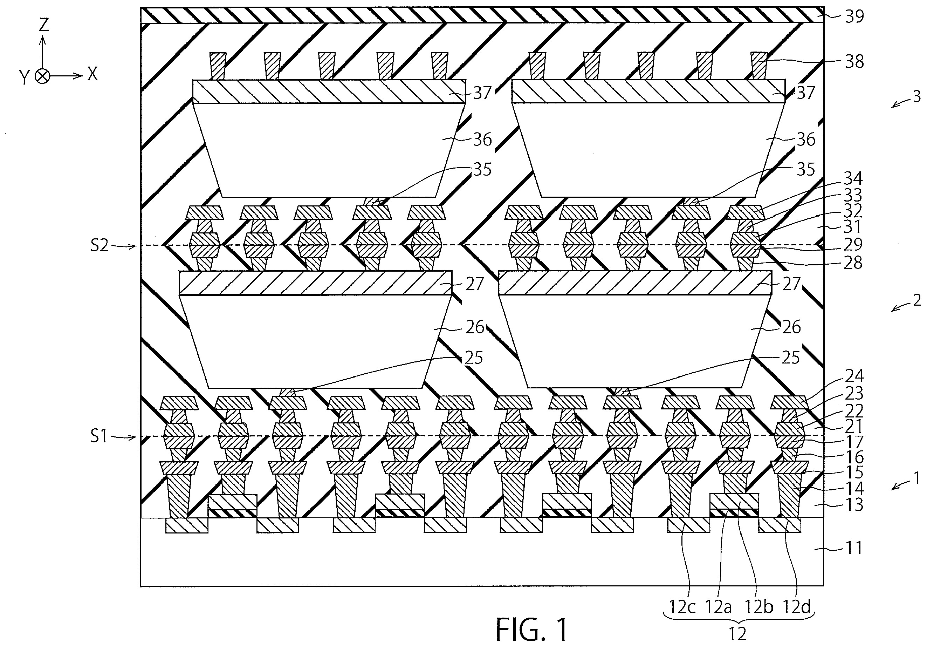

Embodiments will now be explained with reference to the accompanying drawings. In FIGS. 1 to 21D, the same configurations are designated by the same reference numerals and characters, and duplicate description is to be omitted.

In one embodiment, a semiconductor device includes a first substrate, a first insulator provided on the first substrate, a first pad provided in the first insulator, a second insulator provided on the first insulator, and a second pad provided in the second insulator, disposed on the first pad, and being in contact with the first pad. The device further includes a third pad provided in the second insulator, and disposed above the second pad, a third insulator provided on the second insulator, and a fourth pad provided in the third insulator, disposed on the third pad, and being in contact with the third pad. Furthermore, a shape of the third or fourth pad is different from a shape of the first or second pad.

### (First Embodiment)

FIG. 1 is a cross-sectional view showing a structure of a semiconductor device of a first embodiment.

The semiconductor device in FIG. 1 is, for example, a three-dimensional memory in which a circuit chip 1, an array chip 2, and an array chip 3 are bonded together. FIG. 1 shows a bonding face S1 between a circuit chip 1 and an array chip 2 and a bonding face S2 between an array chip 2 and an array chip 3.

The circuit chip 1 includes a substrate 11, a plurality of transistors 12, an inter layer dielectric 13, a plurality of contact plugs 14, a plurality of interconnects 15, a plurality of via plugs 16, and a plurality of metal pads 17. Each transistor 12 includes a gate insulator 12a, a gate electrode 12b, a diffusion layer 12c, and a diffusion layer 12d. The substrate 11 is an example of a first substrate, and the inter layer dielectric 13 is an example of a first insulator. The metal pad 17 is an example of a first pad and an example of a first metal layer.

The array chip 2 includes an inter layer dielectric 21, a plurality of metal pads 22, a plurality of via plugs 23, a plurality of interconnects 24, a plurality of via plugs 25, a plurality of memory cell arrays 26, a plurality of interconnects 27, a plurality of via plugs 28, and a plurality of metal pads 29. The inter layer dielectric 21 is an example of a second insulator, and the metal pad 22 is an example of a second pad and an example of a second metal layer. The memory cell array 26 is an example of a first memory cell array, and the metal pad 29 is an example of a third pad and an example of a third metal layer.

The array chip 3 includes an inter layer dielectric 31, a plurality of metal pads 32, a plurality of via plugs 33, a plurality of interconnects 34, a plurality of via plugs 35, a plurality of memory cell arrays 36, a plurality of interconnects 37, a plurality of via plugs 38, and a passivation film 39. The inter layer dielectric 31 is an example of a third insulator, and the metal pad 32 is an example of a fourth pad and an example of a fourth metal layer. The memory cell array 36 is an example of a second memory cell array.

The substrate 11 is, for example, a semiconductor substrate such as a Si (silicon) substrate. FIG. 1 shows X and Y directions perpendicular to each other and parallel to the surface of the substrate 11, and a Z direction perpendicular to the surface of the substrate 11. In the present specification, the +Z direction is defined as an upward direction, and the -Z direction is defined as a downward direction. The -Z direction may be the same as or may be different from the gravity direction.

Each transistor 12 includes a gate insulator 12a and a gate electrode 12b provided on the substrate 11 in order, and diffusion layers 12c and 12d provided in the substrate 11. The gate electrode 12b of each transistor 12 is formed in the inter layer dielectric 13. The diffusion layers 12c and 12d of each transistor 12 function as a source diffusion layer and a drain diffusion layer. Each transistor 12 forms, for example, a logic circuit that controls the operation of the memory cell arrays 26 and 36.

The inter layer dielectric 13 is formed on the substrate 11. The inter layer dielectric 13 is a stacked insulator including, for example, a silicon oxide film (SiO₂ film) and other insulating films.

The contact plugs 14, the interconnects 15, the via plugs 16, and the metal pads 17 are formed in the inter layer dielectric 13, and are disposed in order on the gate electrode 12b, the diffusion layer 12c, or the diffusion layer 12d. The plurality of contact plugs 14 shown in FIG. 1 may further include contact plugs 14 formed on portions other than the diffusion layers 12c and 12d in the substrate 11. The plurality of interconnects 15 shown in FIG. 1 are provided in the same interconnect layer. Each metal pad 17 includes, for example, a copper (Cu) layer.

The inter layer dielectric 21 is formed on the inter layer dielectric 13. The inter layer dielectric 21 is a stacked insulator including, for example, an SiO₂ film and other insulators.

The metal pads 22, the via plugs 23, the interconnects 24 and the via plugs 25 are formed in the inter layer dielectric 21 and disposed on the metal pads 17 in order. Each metal pad 22 is in contact with the corresponding metal pad 17 and electrically connected with the corresponding metal pad 17. Each metal pad 22 includes, for example, a Cu layer. The plurality of interconnects 24 shown in FIG. 1 are provided in the same interconnect layer.

The memory cell arrays 26 are formed in the inter layer dielectric 21 and disposed on the via plugs 25. The operation of the memory cell arrays 26 is controlled by the above logic circuits via the metal pads 17 and 22. Each memory cell array 26 includes a plurality of memory cells in which data can be stored. Further details of the structure of each memory cell array 26 are to be described below.

The interconnects 27, the via plugs 28, and the metal pads 29 are formed in the inter layer dielectric 21 and disposed on the memory cell array 26 in order. The plurality of interconnects 27 shown in FIG. 1 are provided in the same interconnect layer. These interconnects 27 function as source lines for the memory cell arrays 26, for example. These interconnects 27 may further include interconnects 27 other than the source lines, and the interconnects 27 other than the source lines may be disposed at positions other than positions on the memory cell arrays 26. Each metal pad 29 includes, for example, a Cu layer.

The inter layer dielectric 31 is formed on the inter layer dielectric 21. The inter layer dielectric 31 is a stacked insulator including, for example, an SiO₂ film and other insulators.

The metal pads 32, the via plugs 33, the interconnects 34 and the via plugs 35 are formed in the inter layer dielectric 31 and disposed on the metal pads 29 in order. Each metal pad 32 is in contact with the corresponding metal pad 29 and electrically connected with the corresponding metal pad 29. Each metal pad 32 includes, for example, a Cu layer. The plurality of interconnects 34 shown in FIG. 1 are provided in the same interconnect layer.

The memory cell arrays 36 are formed in the inter layer dielectric 31 and disposed on the via plugs 35. The operation of the memory cell array 36 is controlled by the above logic circuits via metal pads 17, 22, 29 and 32. Each memory cell array 36 includes a plurality of memory cells in which data can be stored. Further details of the structure of each memory cell array 36 are to be described below.

The interconnects 37 and via plugs 38 are formed in the inter layer dielectric 31 and disposed on the memory cell arrays 36 in order. The plurality of interconnects 37 shown in FIG. 1 are provided in the same interconnect layer. These interconnects 37 function as source lines for the memory cell arrays 36, for example. These interconnects 37 may further include interconnects 37 other than the source lines, and the interconnects 37 other than the source lines may be formed at positions other than positions on the memory cell arrays 36.

The passivation film 39 is formed on the inter layer dielectric 31. The passivation film 39 is, for example, a stacked insulator including an SiO₂ film and a silicon nitride film (SiN film).

As described above, the semiconductor device of the present embodiment includes the metal pads 17, 22, 29 and 32, and the metal pads 29 and 32 are disposed above the metal pads 17 and 22. Specifically, the metal pads 17 and 22 are disposed on bonding face S1 and electrically connect the circuit chip 1 and the array chip 2. The metal pads 29 and 32 are disposed on bonding face S2 and electrically connect the array chip 2 and the array chip 3. Each metal pad 22 is disposed on the corresponding metal pad 17 and each metal pad 32 is disposed on the corresponding metal pad 29. In the present embodiment, shapes of the metal pads 29 and 32 are different from shapes of the metal pads 17 and 22, as described below. Further details of shapes of the metal pads 17, 22, 29 and 32 are described below.

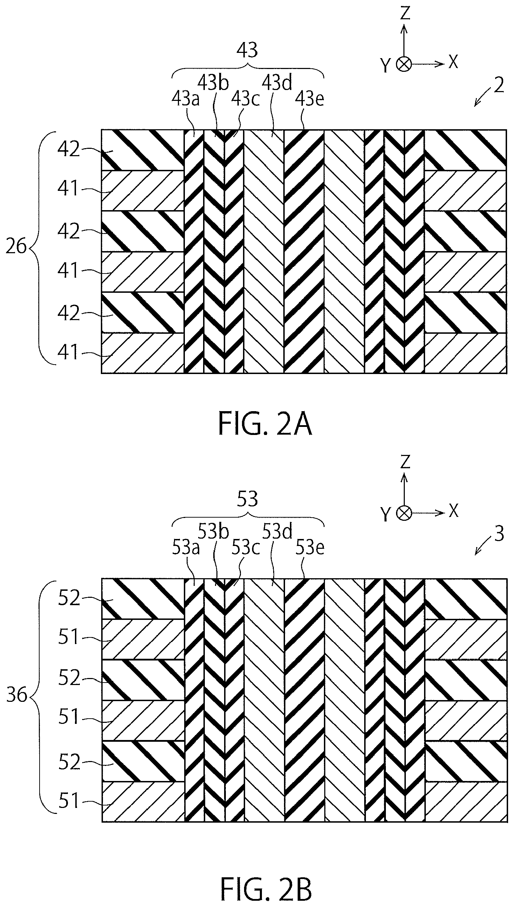

FIGS. 2A and 2B are cross-sectional views showing structures of the memory cell arrays 26 and 36 of the first embodiment.

Each memory cell array 26 of the present embodiment has a structure shown in FIG. 2A. The memory cell array 26 shown in FIG. 2A includes a plurality of electrode layers 41, a plurality of insulators 42, and a plurality of columnar portions 43. FIG. 2A illustrates one of the plurality of columnar portions 43.

The plurality of electrode layers 41 and the plurality of insulators 42 are alternately stacked in the Z direction. Each electrode layer 41 includes, for example, a tungsten (W) layer and functions as a word line. Each insulator 42 is, for example, an SiO₂ film.

Each columnar portion 43 includes a block insulator 43a, a charge storage layer 43b, a tunnel insulator 43c, a channel semiconductor layer 43d, and a core insulator 43e in order, which are sequentially formed on the side faces of the electrode layer 41 and the insulator 42. The block insulator 43a is, for example, an SiO₂ film. The charge storage layer 43b is, for example, an insulator such as a SiN film. The charge storage layer 43b may be a semiconductor layer such as a polysilicon layer. The tunnel insulator 43c is, for example, an SiO₂ film. The channel semiconductor layer 43d is, for example, a polysilicon layer. The core insulator 43e is, for example, an SiO₂ film.

Each memory cell array 36 of the present embodiment has a structure shown in FIG. 2B. The memory cell array 36 shown in FIG. 2B includes a plurality of electrode layers 51, a plurality of insulators 52, and a plurality of columnar portions 53. FIG. 2B illustrates one of the plurality of columnar portions 53.

The plurality of electrode layers 51 and the plurality of insulators 52 are alternately stacked in the Z direction. Each electrode layer 51 includes, for example, a W layer and functions as a word line. Each insulator 52 is, for example, an SiO₂ film.

Each columnar portion 53 includes a block insulator 53a, a charge storage layer 53b, a tunnel insulator 53c, a channel semiconductor layer 53d, and a core insulator 53e in order, which are sequentially formed on the side faces of the electrode layers 51 and the insulators 52. The block insulator 53a is, for example, an SiO₂ film. The charge storage layer 53b is, for example, an insulator such as a SiN film. The charge storage layer 53b may be a semiconductor layer such as a polysilicon layer. The tunnel insulator 53c is, for example, an SiO₂ film. The channel semiconductor layer 53d is, for example, a polysilicon layer. The core insulator 53e is, for example, an SiO₂ film.

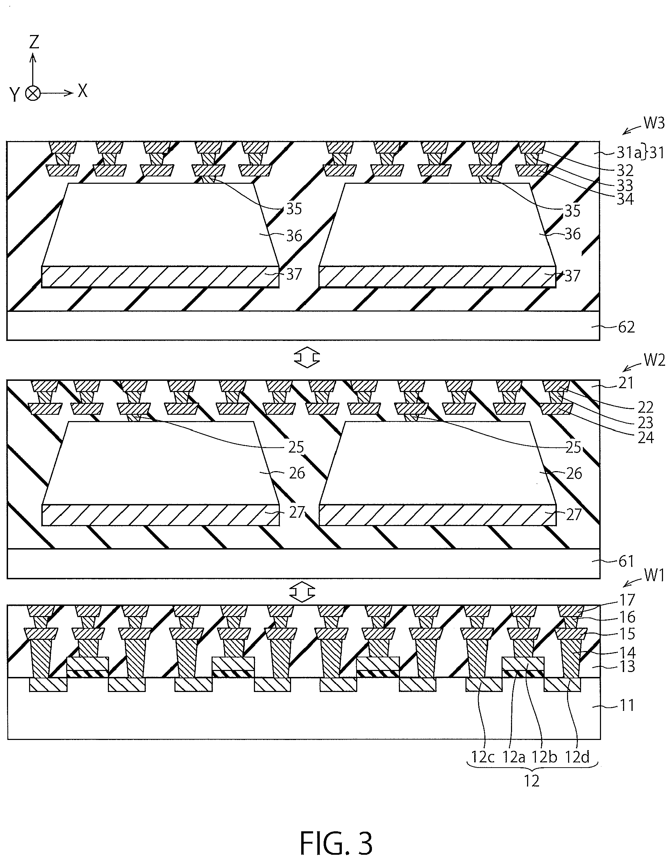

FIGS. 3 to 7 are cross-sectional views showing a method of manufacturing the semiconductor device of the first embodiment.

FIG. 3 shows a circuit wafer W1 including a plurality of circuit chips 1, an array wafer W2 including a plurality of array chips 2, and an array wafer W3 including a plurality of array chips 3. The circuit wafer W1 is also called a CMOS wafer, and the array wafers W2 and W3 are also called memory wafers.

The orientation of array wafers W2 and W3 shown in FIG. 3 is opposite to the orientation of array chips 2 and 3 shown in FIG. 1. In the present embodiment, the circuit wafer W1, the array wafer W2, and the array wafer W3 are bonded together to manufacture a semiconductor device. FIG. 3 shows the array wafers W2 and W3 before being inverted for bonding, and FIG. 1 shows the array chips 2, 3 after they are inverted for bonding, bonded and diced.

In FIG. 3, the array wafer W2 includes a substrate 61 provided under the inter layer dielectric 21, and the array wafer W3 includes a substrate 62 provided under the inter layer dielectric 31. The substrates 61 and 62 are, for example, semiconductor substrates such as Si substrates. The substrate 61 is an example of a second substrate, and the substrate 62 is an example of a third substrate.

The semiconductor device of the present embodiment is manufactured, for example, as follows.

First, transistors 12, inter layer dielectrics 13, contact plugs 14, interconnects 15, via plugs 16, and metal pads 17 are formed on a substrate 11 of a circuit wafer W1 (FIG. 3). Also, an inter layer dielectric 21, metal pads 22, via plugs 23, interconnects 24, via plugs 25, memory cell arrays 26, and interconnects 27 are formed on a substrate 61 of an array wafer W2 (FIG. 3). Further, an insulator 31a, metal pads 32, via plugs 33, interconnects 34, via plugs 35, memory cell arrays 36, and interconnects 37 are formed on a substrate 62 of an array wafer W2 (FIG. 3). The insulator 31a is part of the inter layer dielectric 31. In the process shown in FIG. 3, the process for the circuit wafer W1, the process for the array wafer W2, and the process for the array wafer W3 may be performed in any order.

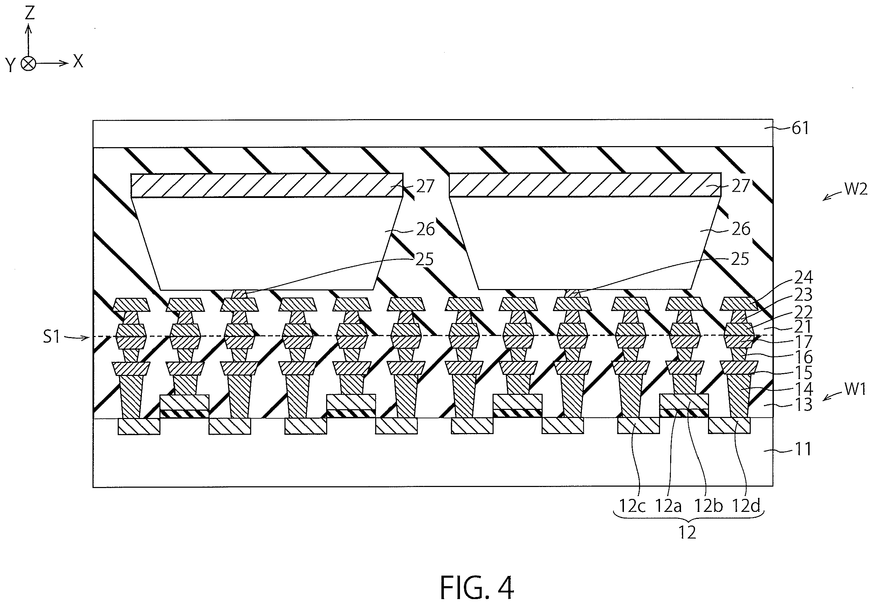

Next, as shown in FIG. 4, the circuit wafer W1 and the array wafer W2 are bonded together by mechanical pressure. As a result, the inter layer dielectric 13 and the inter layer dielectric 21 are adhered together. Next, the circuit wafer W1 and the array wafer W2 are annealed at 400°C (FIG. 4). Thereby, the metal pads 17 and 22 are heated to be joined together. Further details of this annealing is described below in a third embodiment. In this manner, the substrates 11 and 61 are bonded together with the inter layer dielectric 13 and the inter layer dielectric 21 interposed therebetween. The lower face of inter layer dielectric 21 is bonded to the upper face of inter layer dielectric 13.

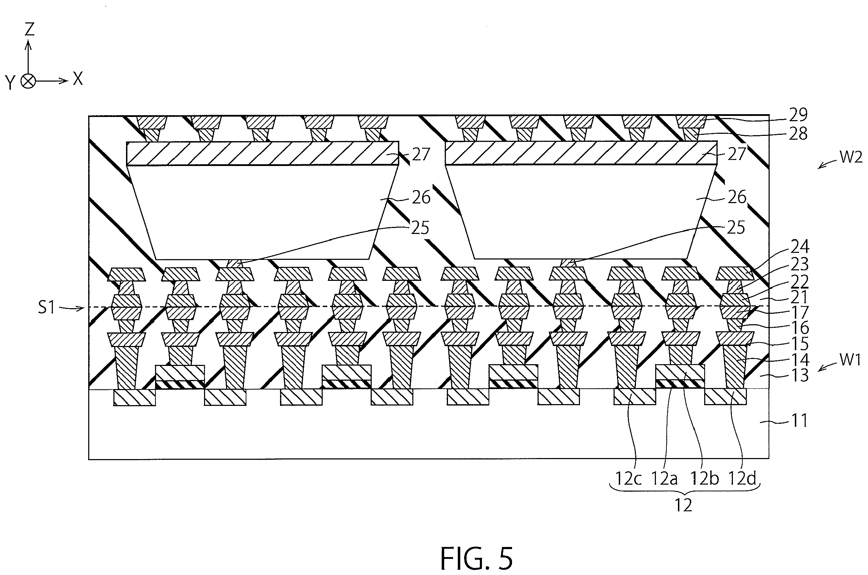

Next, the substrate 61 is removed, and via plugs 28 and metal pads 29 are sequentially formed on the interconnects 27 in the inter layer dielectric 21 (FIG. 5). The substrate 61 is removed by, for example, chemical mechanical polishing (CMP).

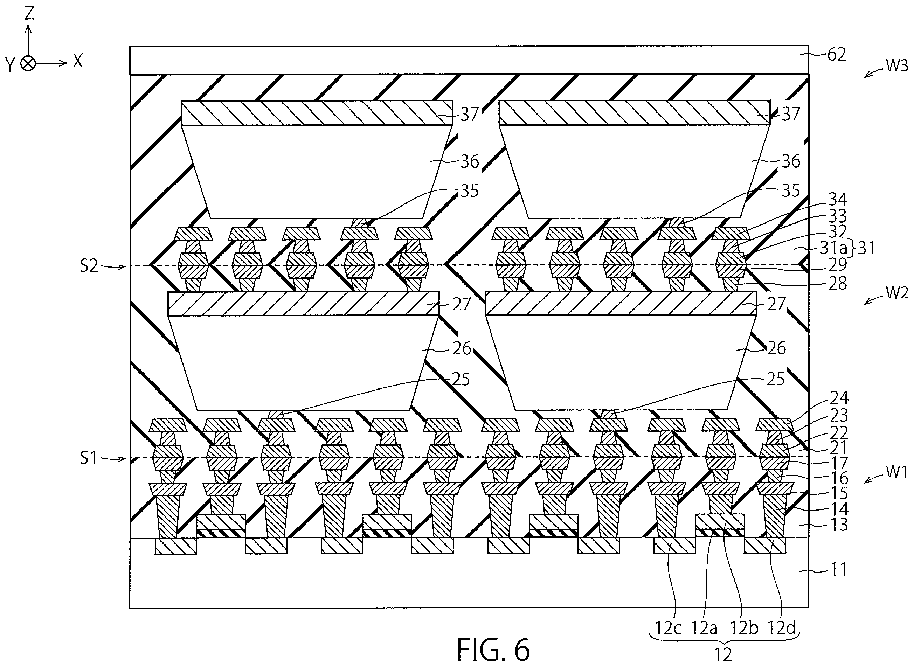

Next, as shown in FIG. 6, the array wafer W2 and the array wafer W3 are bonded together by mechanical pressure. Thereby, the inter layer dielectric 21 and the insulator 31a (inter layer dielectric 31) are adhered. Next, the circuit wafer W1, the array wafer W2, and the array wafer W3 are annealed at 400°C. (FIG. 6). Thereby, the metal pads 17, 22, 29 and 32 are heated, so that the metal pads 29 and 32 are joined. The annealing may be performed such that the metal pads 29 and 32 are heated and the metal pads 17 and 22 are not heated. Further details of this annealing is described below in a third embodiment. In this manner, the substrates 11 and 62 are bonded together via the inter layer dielectric 13, the inter layer dielectric 21, and the insulator 31a. The lower face of the insulator 31a is bonded to the upper face of the inter layer dielectric 21.

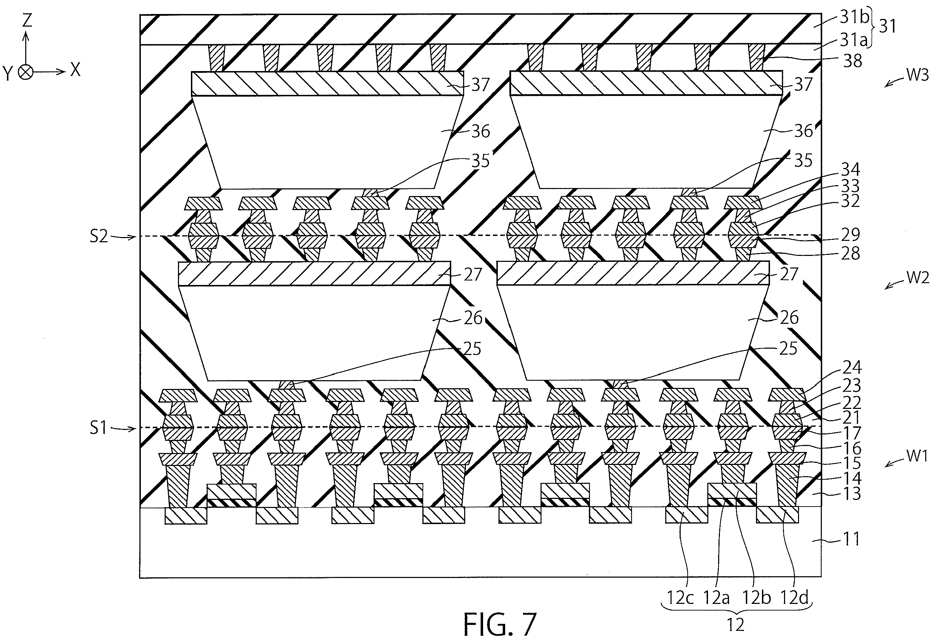

Next, the substrate 62 is removed, via plugs 38 are formed on the interconnects 37 in the insulator 31a, and insulators 31b are formed on the insulator 31a and the via plugs 38 (FIG. 7). The insulator 31b is part of inter layer dielectric 31. The substrate 62 is removed by CMP, for example.

After that, a passivation film 39 (see FIG. 1) is formed on the insulator 31b, and the circuit wafer W1, the array wafer W2, and the array wafer W3 are cut into a plurality of chips. In this way, the semiconductor device of FIG. 1 is manufactured. The substrate 11 may be thinned by CMP before cutting.

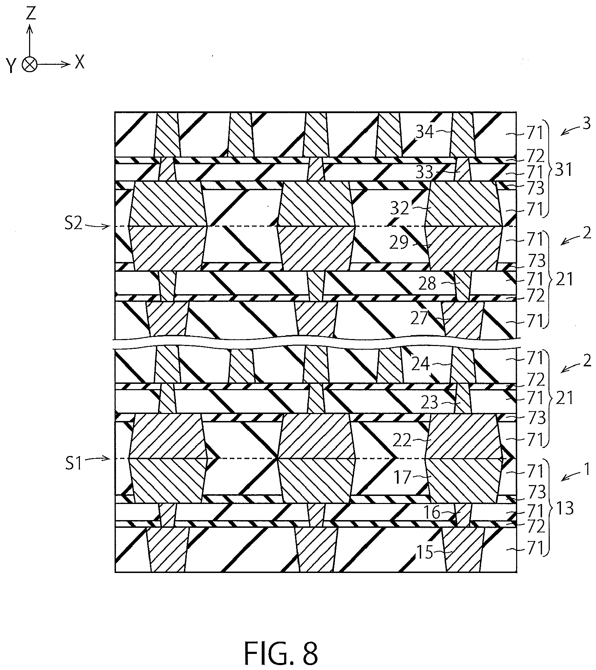

The semiconductor device of the present embodiment is manufactured in such a way that the circuit wafer W1 is bonded to the array wafer W2, and then the array wafer W2 is bonded to the array wafer W3. However, the semiconductor device may be manufactured in such a way that the array wafer W2 is bonded to the array wafer W3, and then the circuit wafer W1 is bonded to the array wafer W2. Also, the semiconductor device of the present embodiment may be manufactured with three or more array wafers bonded together. What are described above with reference to FIGS. 1 to 7 and what are described below with reference to FIGS. 8 to 21D are also applicable to bonding as described in this paragraph.

While FIG. 1 shows the interface between the inter layer dielectric 13 and the inter layer dielectric 21 and the interfaces between the metal pads 17 and the metal pads 22, it is common that these interfaces are not observed after the annealing of FIG. 4. However, the locations where these interfaces have been can be estimated, for example, by detecting the inclination of the side faces of the metal pads 17 or the side faces of the metal pads 22, or detecting the positional deviation between the side faces of the metal pads 17 and the metal pads 22. The same applies to the interface between the inter layer dielectric 21 and the inter layer dielectric 31, the interfaces between the metal pads 29 and the metal pads 32, and the annealing shown in FIG. 6.

Further, the semiconductor device of the present embodiment may be traded in the state shown in FIG. 1 after being cut into a plurality of chips, or may be traded in the state of FIG. 7 before being cut into a plurality of chips. FIG. 1 shows a semiconductor device in a chip state, and FIG. 7 shows a semiconductor device in a wafer state. In the present embodiment, a plurality of chip-state semiconductor devices (FIG. 1) are manufactured from one wafer-state semiconductor device (FIG. 7).

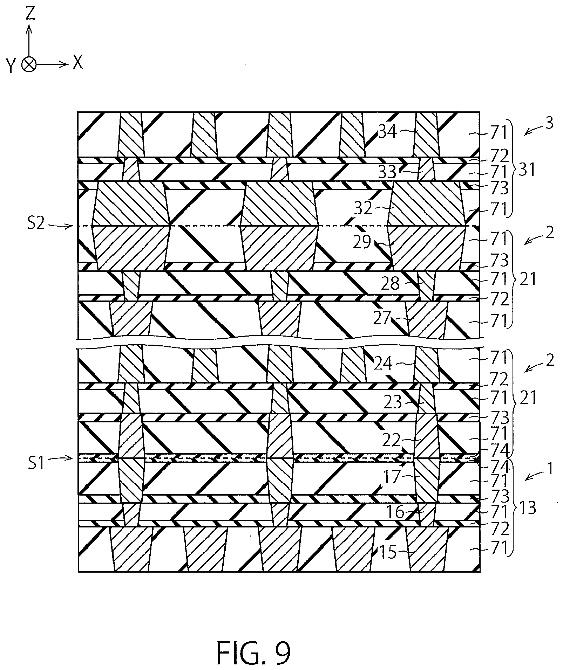

Next, with reference to FIGS. 8 and 9, the semiconductor device of the present embodiment is compared with a semiconductor device of comparative examples.

FIG. 8 is a cross-sectional view showing a structure of a semiconductor device of a comparative example of the first embodiment.

As in FIG. 1, FIG. 8 shows metal pads 17 in the circuit chip 1, metal pads 22 and 29 in the array chip 2, metal pads 32 in the array chip 3, and the like. FIG. 8 further shows insulators 71, 72, and 73 included in the inter layer dielectrics 13, 21, and 31. The insulators 71 are, for example, SiO₂ films. The insulators 72 are, for example, SiN films. The insulators 73 are, for example, SiN films. The insulators 72 are used as etch stoppers in forming via holes for embedding the via plugs 16, 23, 28, and 33. The insulators 73 are used as etch stoppers in forming openings for embedding the metal pads 17, 22, 29 and 32.

In the comparative example, the metal pads 17, 22, 29 and 32 have the same shape. Therefore, in the comparative example, the metal pads 17, 22, 29 and 32 have the same shape in plan view, and the metal pads 17, 22, 29 and 32 have the same thickness. The shape of these metal pads 17, 22, 29 and 32 in plan view is, for example, square, rectangle or circle. The thickness of these metal pads 17, 22, 29 and 32 is the length of the metal pads 17, 22, 29, 32 in the Z direction. In the comparative example, the metal pads 22 and 32 have shapes formed by rotating the shapes of the metal pads 17 and 29 by 180 degrees.

FIG. 9 is a cross-sectional view showing the structure of the semiconductor device of the first embodiment.

FIG. 9 shows insulators 74 included in the inter layer dielectrics 13 and 21 in addition to the components shown in FIG. 8. The insulators 74 are, for example, silicon carbonitride films (SiCN films). In the present embodiment, the upper face of the inter layer dielectric 13 and the lower face of the inter layer dielectric 21 are formed of the insulators 74, and the upper face of the inter layer dielectric 21 and the lower face of the inter layer dielectric 31 are formed of the insulators 71. Therefore, the bonding face S1 of the present embodiment is formed of the insulators 74, and the bonding face S2 of the present embodiment is formed of the insulators 71. One of the insulators 71 and 74 are examples of first insulating materials, and the other of the insulators 71 and 74 are examples of second insulating materia ls.

In the present embodiment, metal pads 17 have the same shape as metal pads 22 and the metal pads 29 have the same shape as metal pads 32, whereas the metal pads 17 and 22 have a different shape from the metal pads 29 and 32. Therefore, in the present embodiment, the shape of the metal pads 17 and 22 differs from the shape of the metal pads 29 and 32 in plan view, and/or the thickness of the metal pads 17 and 22 differs from the thickness of the metal pads 29 and 32. In FIG. 9, the shape of the metal pads 17 and 22 differs from the shape of the metal pads 29 and 32 in plan view, and the thickness of the metal pads 17 and 22 is same as the thickness of the metal pads 29 and 32. In the present embodiment, the metal pads 22 has a shape formed by rotating the shape of the metal pad 17 by 180 degrees in the Z direction, and the metal pad 32 has a shape formed by rotating the shape of the metal pad 29 by 180 degrees in the Z direction.

The interconnects 27 shown in FIG. 1 extend in the X direction, whereas the interconnects 27 shown in FIGS. 8 and 9 extend in the Y direction. Like this, the interconnects 27 of the present embodiment may extend in any direction. The same applies to the other interconnects 15, 24, 34 and 37 of the present embodiment.

The following describes advantage of having different shapes between: the metal pads 17 and 22; and the metal pads 29 and 32, of the present embodiment.

In FIG. 9, the areas of the metal pads 17 and 22 in plan view are set small, and the areas of the metal pads 29 and 32 in plan view are set large. Setting small areas of the metal pads 17 and 22 allows shortening the pitch between the adjacent metal pads 17 and the pitch between the adjacent metal pads 22. This makes it possible to improve integration degree of the metal pads 17 and 22. In contrast, setting the small areas of the metal pads 17 and 22 involves difficulty in appropriately bonding the metal pads 17 and 22 together. For example, if at least one of the circuit wafer W1 and the array wafer W2 has a large warpage, misalignment is likely to occur between the metal pads 17 and the metal pads 22. Setting the small areas of the metal pads 17 and 22 are likely to cause the metal pads 17 and 22 to have high resistance or disconnection even if such misalignment is small.

The process, in which the circuit wafer W1 and the array wafer W2 are bonded together and then the array wafer W2 and the array wafer W3 are bonded together, is highly likely to cause significant wafer warpage when the array wafer W2 and the array wafer W3 are bonded together. Therefore, if the areas of the metal pads 29 and 32 are also set small, the metal pads 29 and 32 are highly likely to have high resistance or disconnection. Contrarily, even if the areas of the metal pads 17 and 22 are set small, the metal pads 29 and 32 are not likely to have high resistance or disconnection. Therefore, in the present embodiment, the areas of the metal pads 17 and 22 are set small, and the areas of the metal pads 29 and 32 are set large. This makes it possible to improve the integration degree of these pads while preventing high resistance and disconnection of these pads.

In FIG. 9, the bonding face S1 is formed of SiCN films (insulators 74), and the bonding face S2 is formed of SiO₂ films (insulators 71). The SiCN films prevent diffusion of Cu atoms more easily than the SiO₂ films. In FIG. 9, a short pitch between the adjacent metal pads 17 and a short pitch between the adjacent metal pads 22 increases the density of the metal pads 17 and 22 occupying the bonding face S1. This increase in density may diffuse a large amount of Cu atoms from the metal pads 17 and 22. The present embodiment makes it possible to form the bonding face S1 with SiCN films to effectively prevent diffusion of Cu atoms from the metal pads 17 and 22 even in a case of increase in the density of the metal pads 17 and 22 occupying the bonding face S1.

The metal pads 17 and 22 and the metal pads 29 and 32 of the present embodiment may have different shapes for another reason. The process, in which the array wafer W2 and the array wafer W3 are bonded together and then the circuit wafer W1 and the array wafer W2 are bonded together, is highly likely to cause significant wafer warpage when the circuit wafer W1 and the array wafer W2 are bonded together. In this case, the areas of the metal pads 17 and 22 may be set large and the areas of the metal pads 29 and 32 may be set small.

Furthermore, the metal pads 22 of the present embodiment have the same shape as the metal pads 17, but may have a different shape from the metal pads 17. Similarly, the metal pads 32 of the present embodiment have the same shape as the metal pads 29, but may have a different shape from the metal pads 29. Furthermore, the plurality of metal pads 17 shown in FIG. 9 may include metal pads 17 having two or more shapes. The same applies to the metal pads 22, 29, and 32.

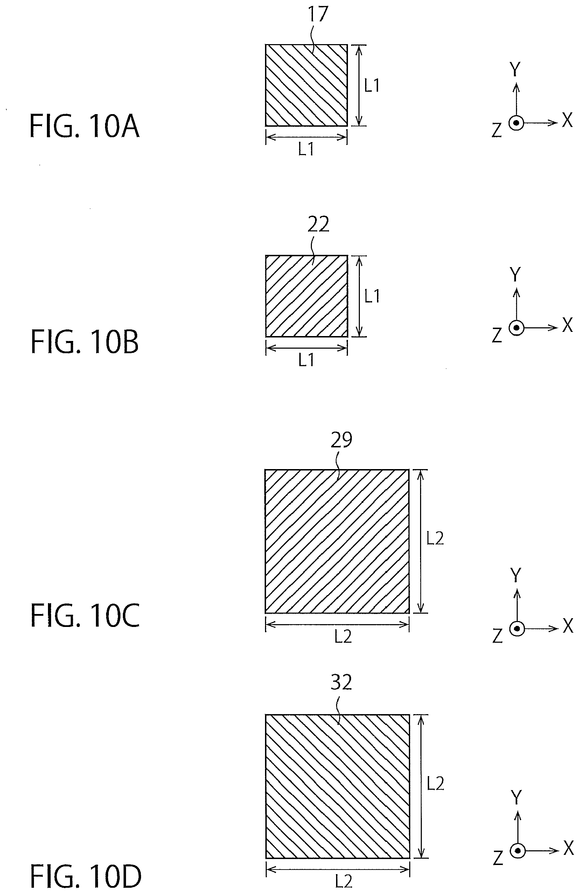

Next, various examples of the metal pads 17, 22, 29 and 32 of the present embodiment are described with reference to FIGS. 10A to 13B.

FIGS. 10A to 10D are plan views showing a first example of the metal pads 17, 22, 29 and 32 of the first embodiment.

FIGS. 10A, 10B, 10C, and 10D respectively show the shapes of the metal pads 17, 22, 29 and 32 in plan view. The metal pads 17 and 22 each have a square shape having four sides of length L1, in plan view. The metal pads 29 and 32 each have a square shape having four sides of length L2 (L1 < L2) in plan view. Therefore, the metal pads 17 and 22 each have a different shape from the metal pads 29 and 32. The thickness of the metal pads 17 and 22 in this example may be the same as the thickness of the metal pads 29 and 32 or may be different from the thickness of the metal pads 29 and 32.

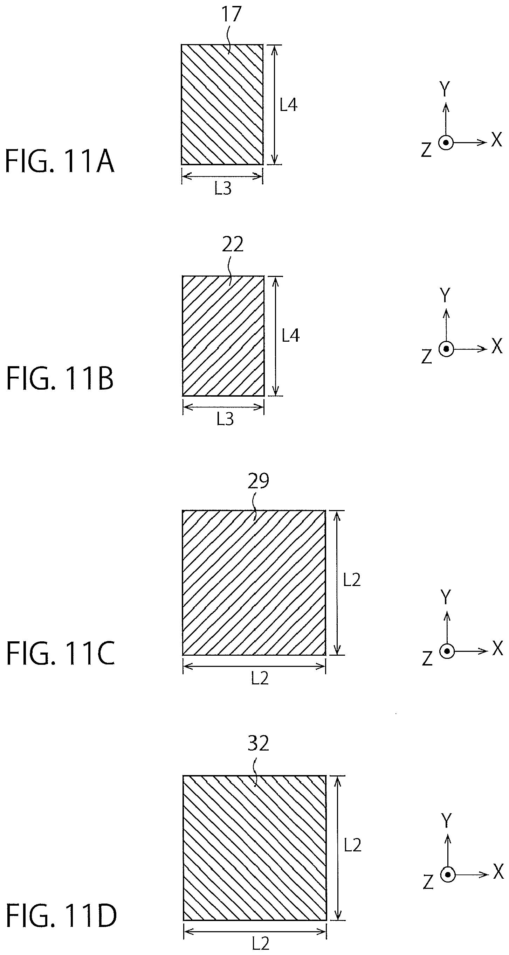

FIGS. 11A to 11D are plan views showing a second example of the metal pads 17, 22, 29 and 32 of the first embodiment.

FIGS. 11A, 11B, 11C, and 11D respectively show the shapes of the metal pads 17, 22, 29 and 32 in plan view. The metal pads 17 and 22 each have a rectangle shape having two sides of length L3 and two sides of length L4 (L3<L4) in plan view. In contrast, the metal pads 29 and 32 each have a square shape having four sides of length L2 in plan view. Therefore, the metal pads 17 and 22 each have a different shape from the metal pads 29 and 32. The thickness of the metal pads 17 and 22 in this example may be the same as the thickness of the metal pads 29 and 32 or may be different from the thickness of the metal pads 29 and 32. In this example, the area L3xL4 of the metal pads 17 and 22 is set smaller than the area L2xL2 of the metal pads 29 and 32 (L3xL4<L2xL2).

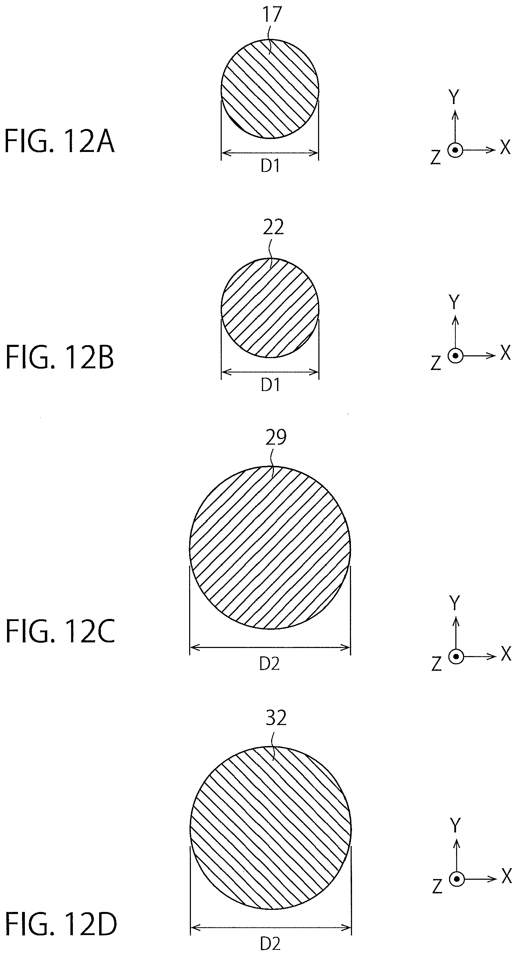

FIGS. 12A to 12D are plan views showing a third example of the metal pads 17, 22, 29 and 32 of the first embodiment.

FIGS. 12A, 12B, 12C, and 12D respectively show the shapes of the metal pads 17, 22, 29 and 32 in plan view. The metal pads 17 and 22 each have a circle shape having a diameter D1 in plan view. In contrast, the metal pads 29 and 32 each have a circle shape having a diameter D2 (D1<D2) in plan view. Therefore, the metal pads 17 and 22 each have a different shape from the metal pads 29 and 32. The thickness of the metal pads 17 and 22 in this example may be the same as the thickness of the metal pads 29 and 32 or may be different from the thickness of the metal pads 29 and 32.

The first and third examples each have an advantage that can shorten both the pitch between metal pads 17 (or 22) in the X direction and the pitch between metal pads 17 (or 22) in the Y direction, for example. The metal pads 17, 22, 29 and 32 may have shapes other than those described in the first, second, and third examples in plan view.

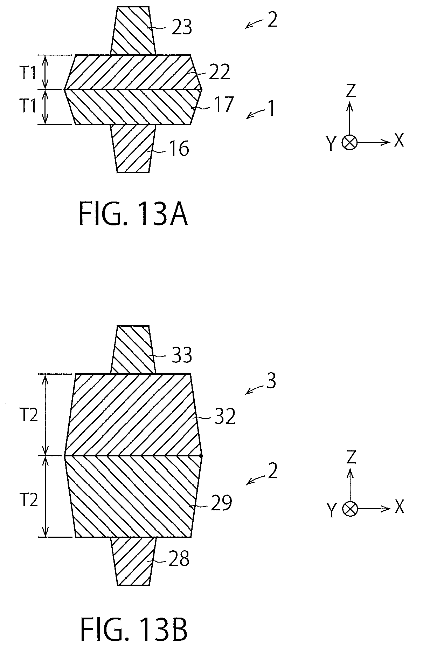

FIGS. 13A and 13B are cross-sectional views showing a fourth example of the metal pads 17, 22, 29 and 32 of the first embodiment.

FIG. 13A shows a vertical section of metal pads 17 and 22, and FIG. 13B shows a vertical section of metal pads 29 and 32. The metal pads 17 and 22 each have a thickness T1 and metal pads 29 and 32 each have a thickness T2 (T1<T2). Therefore, the metal pads 17 and 22 each have a different shape from the metal pads 29 and 32. The shape of the metal pads 17 and 22 in this example may be the same as the shape of the metal pads 29 and 32 or may be different from the shape of the metal pads 29 and 32 in plan view.

Generally, as a metal pad becomes thicker, Cu atoms diffuse more in the amount from the metal pad. Therefore, for the fourth example, the bonding face S1 may be formed of the SiO₂ film, and the bonding face S2 may be formed of the SiCN film. This makes it possible to effectively prevent diffusion of Cu atoms from the metal pads 29 and 32 even if the metal pads 29 and 32 are thick.

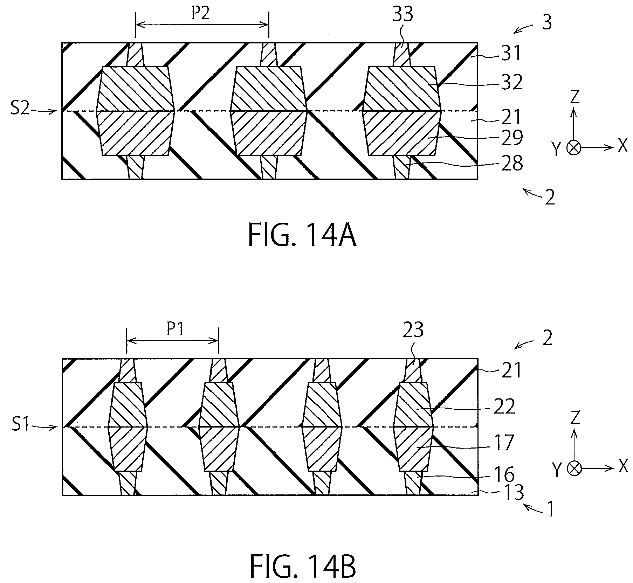

FIGS. 14A to 15B are cross-sectional views for explaining advantages of the semiconductor device of the first embodiment.

FIGS. 14A and 14B show metal pads 17 in the circuit chip 1, metal pads 22 and 29 in the array chip 2, metal pads 32 in the array chip 3, and the like. FIGS. 14A and 14B further show the pitch P1 between adjacent metal pads 17 (or 22) and the pitch P2 between adjacent metal pads 29 (or 32). The present embodiment makes it possible to reduce the areas of the metal pads 17 and 22 in plan view to shorten the pitch P1 as described above. This makes it possible to improve the integration degree of the metal pads 17 and 22.

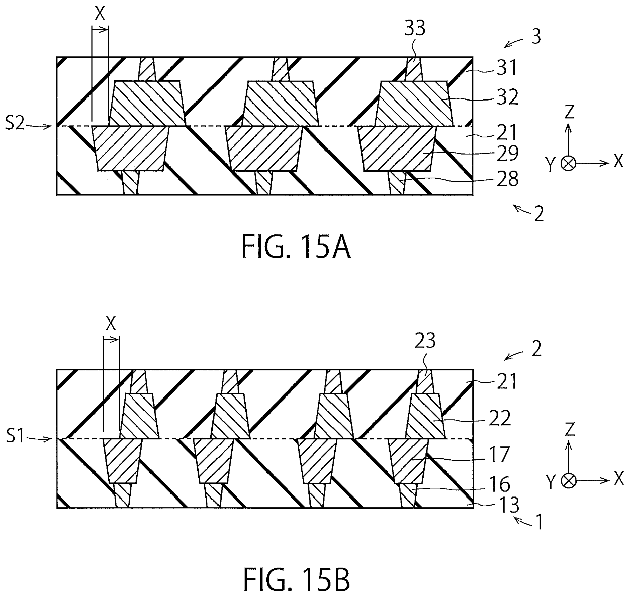

FIGS. 15A and 15B show the width X of misalignment between the metal pads 17 and 22 and between the metal pads 29 and 32. The large areas of the metal pads 29 and 32 are not likely to cause the metal pads 29 and 32 to have high resistance or disconnection due to misalignment. In contrast, the small areas of the metal pads 17 and 22 are likely to cause the metal pads 17 and 22 to have high resistance or disconnection due to misalignment. The misalignment shown in FIG. 15A has the same width X as the misalignment shown in FIG. 15B. However, the misalignment is likely to work more disadvantageously for the metal pads 17 and 22 shown in FIG. 15B than for the metal pads 29 and 32 shown in FIG. 15A.

However, in a case where the circuit wafer W1 and the array wafer W2 are bonded together and then the array wafer W2 and the array wafer W3 are bonded together, the warpage of the wafer is not likely to be large when the circuit wafer W1 and the array wafer W2 are bonded together. This allows the circuit wafer W1 and the array wafer W2 to be bonded together so as to prevent misalignment. Therefore, in the present embodiment, the areas of the metal pads 17 and 22 are set small, and the areas of the metal pads 29 and 32 are set large. This makes it possible to improve the integration degree of these pads while preventing high resistance and disconnection of these pads.

As described above, the shape of the metal pads 29 and 32 of the present embodiment is different from the shape of the metal pads 17 and 22 thereof. Therefore, the present embodiment makes it possible to form these metal pads 17, 22, 29 and 32 in a preferable manner as described above.

### (Second Embodiment)

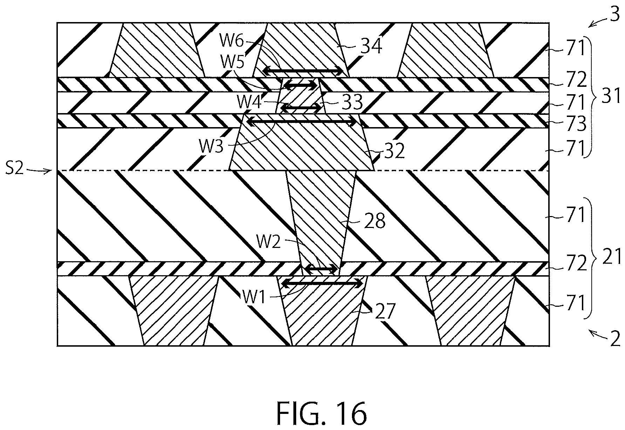

FIG. 16 is a cross-sectional view showing a structure of a semiconductor device of a second embodiment.

The semiconductor device of the present embodiment (FIG. 16) has similar components to the semiconductor device of the first embodiment. However, the array chip 2 of the present embodiment does not include any metal pad 29, but includes a via plug 28 near the bonding face S2. Therefore, the metal pad 32 of the present embodiment is joined to the via plug 28 instead of the metal pad 29, as shown in FIG. 16. The via plug 28 and the metal pad 32 in FIG. 16 are, for example, a W layer and a Cu layer, respectively. The via plug 28 and the metal pad 32 of FIG. 16 are respectively examples of a third metal layer and a fourth metal layer. The semiconductor device of the present embodiment can be manufactured, for example, by omitting the process of forming the metal pad 29 through the method shown in FIGS. 3 to 7.

FIG. 16 shows a width W1 of the upper face of the interconnect 27, a width W2 of the lower face of the via plug 28, a width W3 of the upper face of the metal pad 32, a width W4 of the lower face of the via plug 33, a width W5 of the upper face of the via plug 33, and a width W6 of the interconnect 34. The widths W2, W4 and W5 correspond to the plug diameters of the via plugs 28 and 33 on the upper face or the lower face. The interconnects 27 and 34 shown in FIG. 16 extend in the Y direction, and the widths W1 and W6, which are the lengths in the X direction, correspond to the interconnect widths of the interconnects 27 and 34 on the upper face or the lower face.

In the present embodiment, since the via plug 28 is disposed on the interconnect 27, the width W2 of the via plug 28 is shorter than the width W1 of the interconnect 27 (W2<W1). Also, since the metal pad 32 is disposed under the via plug 33, the width W3 of the metal pad 32 is longer than the width W4 of the via plug 33 (W3>W4). Also, since the via plug 33 is disposed under the interconnect 34, the width W5 of the via plug 33 is shorter than the width W6 of the interconnect 34 (W5<W6).

The structure of the via plug 28 of the present embodiment may be applied to the via plug 33 instead of the via plug 28. In this case, array chip 3 does not include any metal pad 32 and the metal pad 29 are joined to the via plug 33 instead of metal pad 32. Similarly, the structure of via plug 28 of the present embodiment may be applied to either via plug 16 or 23.

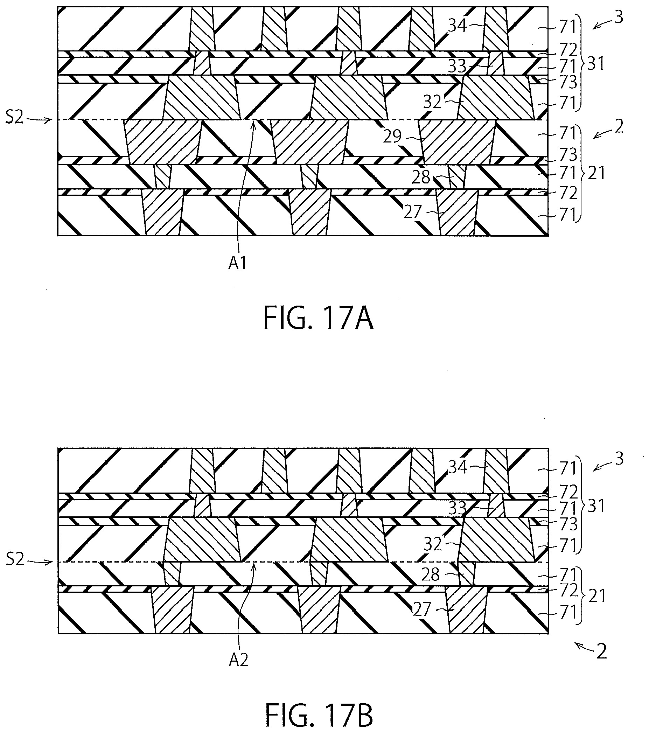

FIGS. 17A and 17B are a cross-sectional view for comparing the semiconductor device of the second embodiment and a semiconductor device of a comparative example thereof.

FIG. 17A shows the semiconductor device of the comparative example. In FIG. 17A, the metal pads 32 are joined to the metal pads 29. In FIG. 17A, the metal pads 29 and 32 are misaligned.

FIG. 17B shows the semiconductor device of the present embodiment. In FIG. 17B, the metal pads 32 are joined to the via plugs 28. In FIG. 17B, the via plugs 28 and the metal pads 32 are misaligned.

An arrow A1 shown in FIG. 17A indicates a gap between a metal pad 29 and a metal pad 32 of the comparative example. Both the size of the metal pad 29 and the size of the metal pad 32 are large, resulting in a very short gap between the metal pads 29 and 32 due to the misalignment. This may deteriorate the breakdown voltage of the semiconductor device due to, for example, a short circuit between the metal pads 29 and 32.

An arrow A2 shown in FIG. 17B indicates a gap between a via plug 28 and a metal pad 32 of the present embodiment. The size of the via plug 28 is small, reliably providing a long gap between the via plug 28 and the metal pad 32 even if they are misaligned. Therefore, the present embodiment makes it possible to prevent the deterioration of the breakdown voltage of the semiconductor device, such as by preventing a short circuit between the via plug 28 and the metal pad 32.

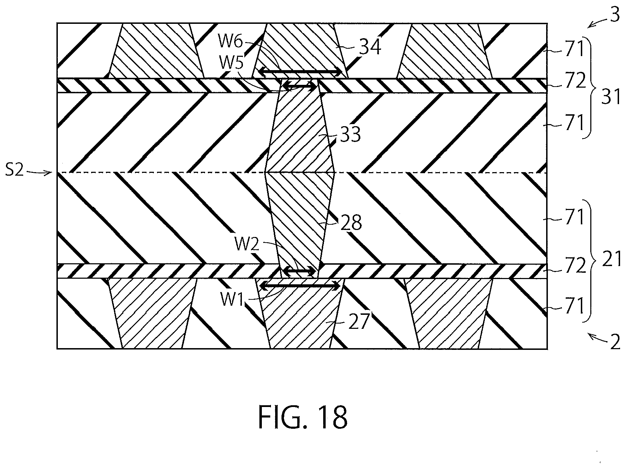

FIGS. 18 to 19C are cross-sectional views showing structures of semiconductor devices of first to fourth modifications of the second embodiment.

The semiconductor device of the first modification (FIG. 18) has similar components to the semiconductor device of the first embodiment. However, the array chips 2 and 3 of the present modification do not include the metal pads 29 and 32, and have the via plugs 28 and 33 near the bonding face S2. Therefore, the via plug 33 of the present embodiment is joined to the via plug 28 as shown in FIG. 18. The via plugs 28 and 33 in FIG. 18 are W layers, for example. The via plugs 28 and 33 of FIG. 18 are examples of third and fourth metal layers, respectively. The semiconductor device of the present modification can be manufactured, for example, by omitting the processes of forming the metal pads 29 and 32 through the method shown in FIGS. 3 to 7. The present modification makes it possible to prevent the deterioration of the breakdown voltage of the semiconductor device, such as by preventing a short circuit between the via plugs 28 and 33 as in the second embodiment.

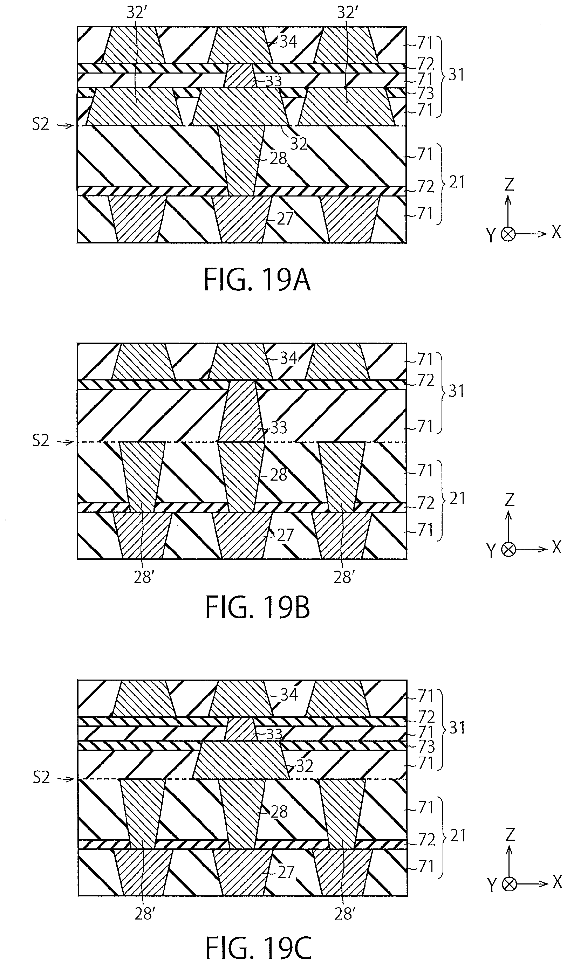

The semiconductor device of the second modification (FIG. 19A) includes a plurality of metal pads (dummy pads) 32' in addition to the components shown in FIG. 16. These metal pads 32' are formed of the same material as the metal pads 32. The semiconductor device of the third modification (FIG. 19B) includes a plurality of via plugs (dummy plugs) 28' in addition to the components shown in FIG. 18. These via plugs 28' are formed of the same material as the via plugs 28. The semiconductor device of the fourth modification (FIG. 19C) includes a plurality of via plugs (dummy plugs) 28' in addition to the components shown in FIG. 16. These via plugs 28' are formed of the same material as the via plugs 28.

In this way, when the structure of the second embodiment or the first modification is adopted, the array chip 2 or array chip 3 may include dummy pads 32' or dummy plugs 28'. The dummy pads 32' are metal pads that are not used as pads for electrically connecting components in the semiconductor device. The dummy plugs 28' are via plugs that are not used as plugs for electrically connecting components in the semiconductor device. The dummy pads 32' and the dummy plugs 28' can prevent CMP erosion. When the structure of the second embodiment or the first modification is adopted, the dummy pads 32' (or dummy plugs 28') are desirably disposed on only one of array chips 2 and 3 as shown in FIGS. 19A to 19C, to reliably provide wide gaps indicated by the arrows A1 and A2.

As described above, the array chips 2 and 3 of the present embodiment have a structure in which the metal pads 32 and the via plugs 28 are joined together, or a structure in which the via plugs 33 and the via plugs 28 are joined together. Therefore, the present embodiment makes it possible to form these metal pads 32, and via plugs 28 and 33 in a preferable manner as described above. The present embodiment makes it possible to provide the via plugs 28 and 33 with a similar function as bonding pads such as the metal pads 32.

The structures of the second embodiment and the first to fourth modifications may be applied to the bonding face S1 instead of the bonding face S2. However, in a case where the circuit wafer W1 and the array wafer W2 are bonded together and then the array wafer W2 and the array wafer W3 are bonded together, wafer warpage is highly likely to be significant when the array wafer W2 and the array wafer W3 are bonded together. In this case, misalignment between the metal pads is likely to occur when the array wafer W2 and the array wafer W3 are bonded together. Therefore, in this case, it is preferable to apply the structures of the second embodiment and the first to fourth modifications to the bonding face S2 rather than to the bonding face S1.

### (Third Embodiment)

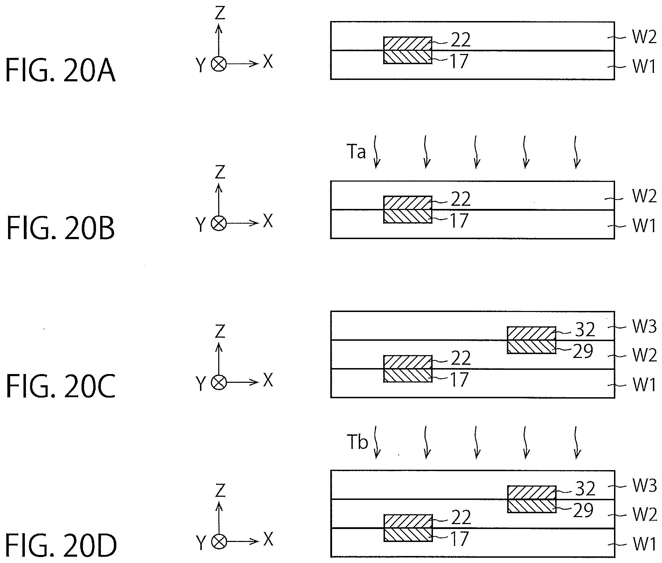

FIG. 20 is a cross-sectional view showing a method of manufacturing a semiconductor device of a third embodiment.

The method of manufacturing the semiconductor device of the present embodiment is similar to the method of manufacturing the semiconductor device of the first embodiment shown in FIGS. 3 to 7. However, in the present embodiment, the annealing temperature immediately after bonding the array wafers W2 and W3 is set to a temperature different from the annealing temperature immediately after bonding the circuit wafer W1 and the array wafer W2.

First, the circuit wafer W1 and the array wafer W2 are bonded together (FIG. 20A). Next, the circuit wafer W1 and array wafer W2 are annealed at a temperature Ta (FIG. 20B). Thereby, the metal pads 17 and 22 are heated. The temperature Ta is an example of a first temperature.

The metal pads 17 and 22 of the present embodiment include, for example, Cu layers. The Cu layers can be sufficiently joined together by annealing to 400°C or higher. However, the annealing in FIG. 20B is performed at a temperature Ta that is set to lower than 400°C. Therefore, the metal pads 17 and 22 of the present embodiment are not sufficiently joined by the annealing shown in FIG. 20B. The annealing in FIG. 20B is performed for one hour at a temperature Ta that is set to lower than 300°C, for example. The annealing promotes binding of the inter layer dielectric 13 and the inter layer dielectric 21, but does not sufficiently join the metal pads 17 and the metal pads 22.

Next, the array wafer W2 and the array wafer W3 are bonded together (FIG. 20C). Then, the circuit wafer W1, the array wafer W2, and the array wafer W3 are annealed at a temperature Tb different from the temperature Ta (FIG. 20D). Thereby, the metal pads 17, 22, 29 and 32 are heated. The temperature Tb is an example of a second temperature.

The metal pads 29 and 32 of the present embodiment include, for example, Cu layers. The annealing in FIG. 20D is performed at a temperature Tb that is set to 400°C or higher. Therefore, the metal pad 17 and the metal pad 22 of the present embodiment are sufficiently joined by the annealing shown in FIG. 20D, and the metal pads 29 and the metal pads 32 of the present embodiment are also sufficiently joined by the annealing shown in FIG. 20D. The annealing in FIG. 20D is performed for one hour at a temperature Tb that is set to 400°C, for example. This annealing not only promotes binding of the inter layer dielectric 21 and the inter layer dielectric 31, but also joins the metal pads 17 and the metal pads 22 sufficiently and joins the metal pads 29 and the metal pads 32 sufficiently.

If the temperature Ta is set to 400°C or higher, the metal pads 17 and 22 are sufficiently joined by annealing shown in FIG. 20B, and are further exposed to a temperature at which they can be sufficiently joined by annealing in FIG. 20D. As a result, excessive stress may be applied to the metal pads 17 and 22, and a large amount of Cu atoms may diffuse from the metal pads 17 and 22. In contrast, the present embodiment makes it possible to prevent these problems by setting the temperature Ta lower than 400°C.

The diffusion of Cu atoms is considered to have a large adverse effect on the circuit wafer W1. Therefore, it is desirable to prevent diffusion of Cu atoms from the metal pads 17 and 22 closer to the circuit wafer W1 more than diffusion of Cu atoms from the metal pads 29 and 32 far from the circuit wafer W1. The present embodiment makes it possible to perform annealing of FIG. 20B that heats only metal pads 17 and 22 at a low temperature among the metal pads 17, 22, 29 and 32 to effectively prevent diffusion of Cu atoms from the metal pads 17 and 22.

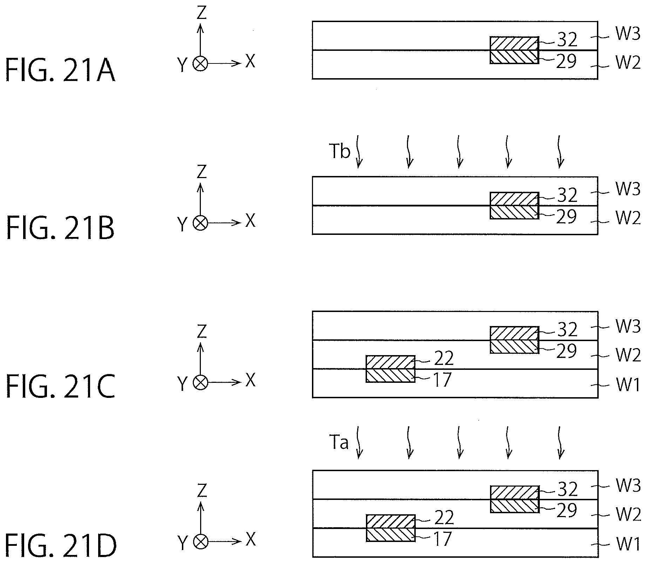

The temperature Ta may be set to a temperature different from the temperature Tb for another reason. For example, a semiconductor device may be manufactured through the method shown in FIGS. 21A to 21D.

FIGS. 21A to 21D are cross-sectional views showing a method of manufacturing a semiconductor device of a modification of the third embodiment.

First, the array wafer W2 and the array wafer W3 are bonded together (FIG. 21A). Next, array wafer W2 and array wafer W3 are annealed at a temperature Tb (FIG. 21B). Thereby, the metal pads 29 and 32 are heated. The temperature Tb is also an example of the second temperature.

The metal pads 29 and 32 of the present modification include, for example, Cu layers. The annealing in FIG. 21B is performed at a temperature Tb that is set to 400°C or higher. Therefore, the metal pads 29 and the metal pads 32 of the present modification are sufficiently joined by the annealing shown in FIG. 21B. The annealing in FIG. 21B is performed for one hour at a temperature Tb that is set to 420°C, for example. The annealing not only promotes binding of the inter layer dielectric 21 and the inter layer dielectric 31, but also sufficiently joins the metal pads 29 and the metal pads 32 together.

Next, the circuit wafer W1 and the array wafer W2 are bonded together (FIG. 21C). Then, the circuit wafer W1, the array wafer W2, and the array wafer W3 are annealed at a temperature Ta different from the temperature Tb (FIG. 21D). Thereby, the metal pads 17, 22, 29 and 32 are heated. The temperature Ta is also an example of the first temperature.

The metal pads 17 and 22 of the present modification include, for example, Cu layers. The annealing in FIG. 21D is performed at a temperature Ta that is set to 400°C or higher. Therefore, the metal pads 17 and the metal pads 22 of the present modification are sufficiently joined by the annealing shown in FIG. 21D. The annealing in FIG. 21D is performed for one hour at a temperature Ta that is set to 400°C, for example. The annealing not only promotes binding of the inter layer dielectric 13 and the inter layer dielectric 21, but also sufficiently joins the metal pads 17 and the metal pads 22 together.

As described above, it is desirable to prevent diffusion of Cu atoms from the metal pads 17 and 22 closer to the circuit wafer W1 more than diffusion of Cu atoms from the metal pads 29 and 32 far from the circuit wafer W1. The present modification makes it possible to heat the metal pads 17 and 22 only by the annealing shown in FIG. 21D among the annealing shown in FIGS. 21B and 21D to effectively prevent diffusion of Cu atoms from the metal pads 17 and 22. In addition, the present modification makes it possible to set the temperature Ta lower than the temperature Tb to anneal the metal pads 17 and 22 at a lower temperature, resulting in more effective prevention of diffusion of Cu atoms from the metal pads 17 and 22.

As described above, the present embodiment makes it possible to set the temperature Tb to a temperature different from the temperature Ta to form the metal pads 17, 22, 29 and 32 in a preferable manner. The temperature Tb is set higher than the temperature Ta in the above description. Contrarily, the scheme of setting temperature Tb lower than the temperature Ta may be adopted.

The method of the present embodiment may be applied to the manufacturing of the semiconductor device of the second embodiment instead of the manufacturing of the semiconductor device of the first embodiment. In this case, the annealing in the present embodiment not only joins metal pads together, but also joins metal pads and via plugs or joins via plugs together.

The embodiments described above may be implemented as below.
[1] A semiconductor device including:
   a first substrate;
   a first insulator provided on the first substrate;
   a first metal layer provided in the first insulator;
   a second insulator provided on the first insulator;
   a second metal layer provided in the second insulator, disposed on the first metal layer, and being in contact with the first metal layer;
   a third metal layer provided in the second insulator and disposed above the second metal layer;
   a third insulator provided on the second insulator; and
   a fourth metal layer provided in the third insulator, disposed on the third metal layer, and being in contact with the third metal layer,
   wherein the first, second, third or the fourth metal layer is a plug provided on a surface of an interconnect.
[2] The device of [1], wherein
   one of the first and second metal layers or one of the third and fourth metal layers is a plug provided on a surface of an interconnect, and
   another of the first and second metal layers or another of the third and fourth metal layers is a pad provided on a surface of an interconnect via a plug.
[3] The device of [1], wherein
   one of the first and second metal layers or one of the third and fourth metal layers is a plug provided on a surface of an interconnect, and
   another of the first and second metal layers or another of the third and fourth metal layers is a plug provided on a surface of an interconnect.
[4] The device of [1], further including:
   a first memory cell array provided in the second insulator; and
   a second memory cell array provided in the third insulator.
[5] The device of [4], further including a circuit provided in the first insulator, and configured to control the first and second memory cell arrays.

While certain embodiments have been described, these embodiments have been presented by way of example only, and are not intended to limit the scope of the inventions. Indeed, the novel devices and methods described herein may be embodied in a variety of other forms; furthermore, various omissions, substitutions and changes in the form of the devices and methods described herein may be made without departing from the scope of the inventions.

## Claims

1. A semiconductor device comprising:
a first substrate;
a first insulator provided on the first substrate;
a first pad provided in the first insulator;
a second insulator provided on the first insulator;
a second pad provided in the second insulator, disposed on the first pad, and being in contact with the first pad;
a third pad provided in the second insulator, and disposed above the second pad;
a third insulator provided on the second insulator; and
a fourth pad provided in the third insulator, disposed on the third pad, and being in contact with the third pad,
wherein a shape of the third or fourth pad is different from a shape of the first or second pad.

2. The device of Claim 1, wherein the shape of the third or fourth pad in plan view is different from the shape of the first or second pad in plan view.

3. The device of Claim 1 or 2, wherein a thickness of the third or fourth pad is different from a thickness of the first or second pad.

4. The device of any of Claims 1 to 3, further comprising:
a first memory cell array provided in the second insulator; and
a second memory cell array provided in the third insulator.

5. The device of Claim 4, further comprising a circuit provided in the first insulator, and configured to control the first and second memory cell arrays.

6. The device of any of Claims 1 to 5, wherein
an upper face of the first insulator or a lower face of the second insulator is formed of a first insulating material, and
an upper face of the second insulator or a lower face of the third insulator is formed of a second insulating material different from the first insulating material.

7. The device of Claim 6, wherein
one of the first and second insulating materials includes silicon and oxygen, and
another of the first and second insulating materials includes silicon, carbon and nitrogen.

8. A method of manufacturing a semiconductor device, comprising:
forming a first insulator on a first substrate;
forming a first metal layer in the first insulator;
forming a second insulator on a second substrate;
forming a second metal layer and a third metal layer in the second insulator;
forming a third insulator on a third substrate;
forming a fourth metal layer in the second insulator;
bonding the first and second insulators so that the first metal layer is in contact with the second metal layer, and annealing at least the first and second metal layers at a first temperature after bonding the first and second insulators; and
bonding the second and third insulators so that the third metal layer is in contact with the fourth metal layer, and annealing at least the third and fourth metal layers at a second temperature after bonding the second and third insulators,
wherein the second temperature is different from the first temperature.

9. The method of Claim 8, wherein the bonding of the second and third insulators is performed after the annealing at the first temperature.

10. The method of Claim 8, wherein the bonding of the first and second insulators is performed after the annealing at the second temperature.

11. The method of any of Claims 8 to 10, further comprising:
forming a first memory cell array on the second substrate; and
forming a second memory cell array on the third substrate.

12. The method of Claim 11, further comprising forming a circuit of controlling the first and second memory cell arrays, on the first substrate.

13. The method of Claim 12, wherein the second temperature is higher than the first temperature.

14. The method of any of Claims 8 to 13, wherein the first, second, third and fourth metal layers are a first, second, third and fourth pads, respectively.

15. The method of any of Claims 8 to 14, wherein the first, second, third or fourth metal layer is a plug provided on a surface of an interconnect.
